# EUROPEAN PATENT SPECIFICATION

(11) **EP 3 016 487 B1**
(45) Date of publication and mention of the grant of the patent: **15.01.2020**
(21) Application number: 15191848.9
(22) Date of filing: 28.10.2015
(51) Int. Cl.: H05K 7/14, H05K 1/14, H05K 3/36

(54) **A UNIFIED MANUFACTURING PROCESS FOR A SINGLE FLEX CONNECTOR AND PRINTED WIRING BOARDS FOR ELECTRIC SYSTEM CONTROLLER**
EINHEITLICHES HESTELLUNGSVERFAHREN FÜR EINEN EINZELNEN FLEXIBLEN STECKVERBINDER UND GEDRUCKTE LEITERPLATTEN FÜR EINE ELEKTROSYSTEMSTEUERUNG
PROCÉDÉ DE FABRICATION UNIFIÉ POUR UN CONNECTEUR DE CÂBLAGE SOUPLE ET CIRCUITS IMPRIMÉS POUR UN SYSTÈME ÉLECTRIQUE DE COMMANDE

(30) Priority: 28.10.2014 US 201462069636 P
(43) Date of publication of application: 04.05.2016
(73) Proprietor: Hamilton Sundstrand Corporation, Charlotte, NC 28217 (US)
(72) Inventor: RALPH, Wes, Rockford, IL 61114 (US)
(74) Representative: Dehns

(56) References cited:
- WO-A2-2005/104324
- WO-A2-2013/167588
- US-A1- 2009 263 990
- US-A1- 2009 322 149
- US-A1- 2014 211 432
- US-B1- 6 545 875

## Description

### BACKGROUND OF THE INVENTION

An electric system controller includes large connectors that receive printed wiring board backplanes. Each printed wiring board backplane further includes a plurality of sub-connectors, each of which receives a printed wiring board slot card. In this way, the printed wiring board backplane is used in the electric system controllers to allow for the multiple printed wiring board slot cards to fit into and connect to the electric system controller. However, the printed wiring board backplane unnecessarily expands the dimensions and increases the weight of the electric system controllers when less than three printed wiring board slot cards are utilized. These dimension and weight penalties are especially costly in the aerospace industry, were fuel efficiency directly relates to total vehicle weight.

US 6,545,875 teaches a first printed wiring board with a first connector, a second printed wiring board with a second connector and a flex connector configured to electrically connect the first and second printed wiring boards and to fold back on itself to enable a parallel alignment of the first and second printed wiring boards.

### BRIEF DESCRIPTION OF THE INVENTION

According to an aspect of the present invention, there is provided a method as defined in claim 1.

### BRIEF DESCRIPTION OF THE DRAWINGS

The subject matter which is regarded as the invention is particularly pointed out and distinctly claimed in the claims at the conclusion of the specification. The foregoing and other features, and advantages of the invention are apparent from the following detailed description taken in conjunction with the accompanying drawings in which:
FIG. 1 is an example of a schematic of a device;
FIG. 2 is another example of a schematic of a device;
FIG. 3 is another example of a schematic of a device according to one embodiment;
FIG. 4 is another example of a schematic of a device; and
FIG. 5 is an example of a schematic of a processing system.

### DETAILED DESCRIPTION OF THE INVENTION

As indicated above, the printed wiring board backplane unnecessarily expands the dimensions and increases the weight of the electric system controllers when less than three printed wiring board slot cards are utilized. Thus, what is needed is a novel mechanical design approach that will remove the necessity for a printed wiring board backplane, resulting in lower cost, weight, and dimensions of the electric system controller.

In general, a device including at least one connector between two printed wiring boards is employed by a processing system (e.g., an electric system controller). For example, in the aerospace industry, a vehicle or aircraft may decrease dimension and weight penalties by utilizing the device described herein in an electric system controller of that vehicle or aircraft. In this way, the vehicle or aircraft will gain fuel efficiency directly related to a decrease in total vehicle weight produced by the employment of the device herein.

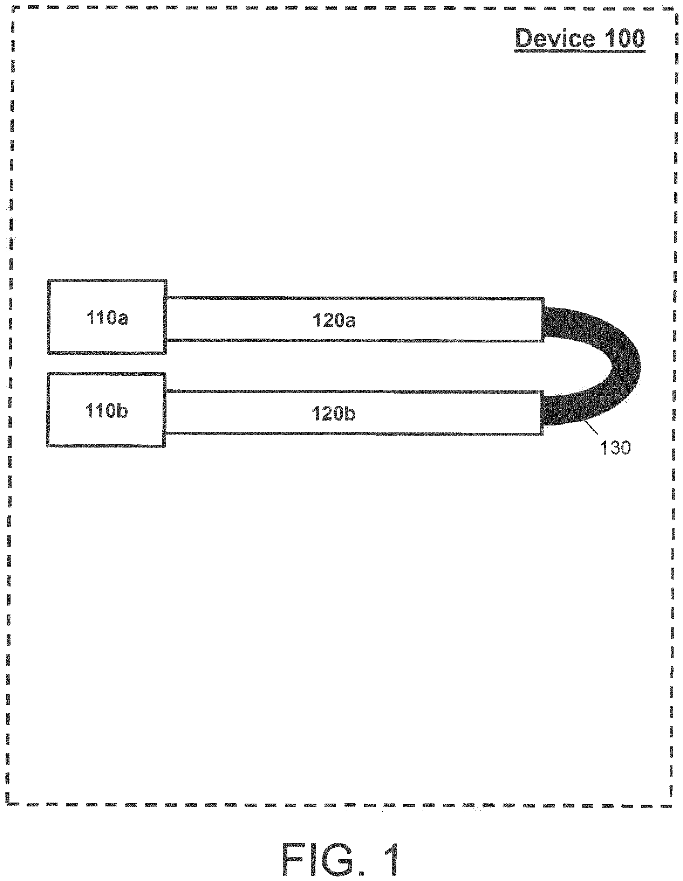

FIG. 1 is an example of a schematic of a device 100 not falling within the scope of claim 1. The device 100, as illustrated includes connectors 110a, 110b, printed wiring boards 120a, 120b, and a flex connector 130.

The connectors 110a, 110b enable the printed wiring boards 120a, 120b to electrically and mechanically connect to electric system controller and/or any processing device. Examples of the connectors 110a, 110b include right angle connectors that mechanically solder the printed wiring boards 120a, 120b to pins that connect to a processing system.

The printed wiring boards 120a, 120b mechanically support and electrically connect electronic components using conductive tracks, pads, and other features etched from conductive sheets laminated onto a non-conductive substrate. The printed wiring boards 120a, 120b can be single sided (one conductive layer), double sided (two conductive layers) or multi-layer. The different conductive layers can be connected with plated-through holes called vias. Examples of the printed wiring boards 120a, 120b include printed wiring boards configured to control a fuel system and/or an electrical system of an aircraft.

The flex connector 130 is a conductive trace that electrically and mechanically connects the printed wiring boards 120a, 120b to enable communication. The flex connector 130 is capable of being folded onto itself, and thus allowing for the printed wiring boards 120a, 120b to align in parallel as a single processing device 100. In addition, the flex connector 130 enables a unified manufacturing process for the device, in that the flex connector 130 and the printed wiring boards 120a, 120b may be processed, coated, and cleaned as a single unit (e.g., as opposed to individual pieces). Thus, the flex connector 130 enables the device 100 to lower manufacturing costs for a processing system, along with reducing the dimension and weight penalty.

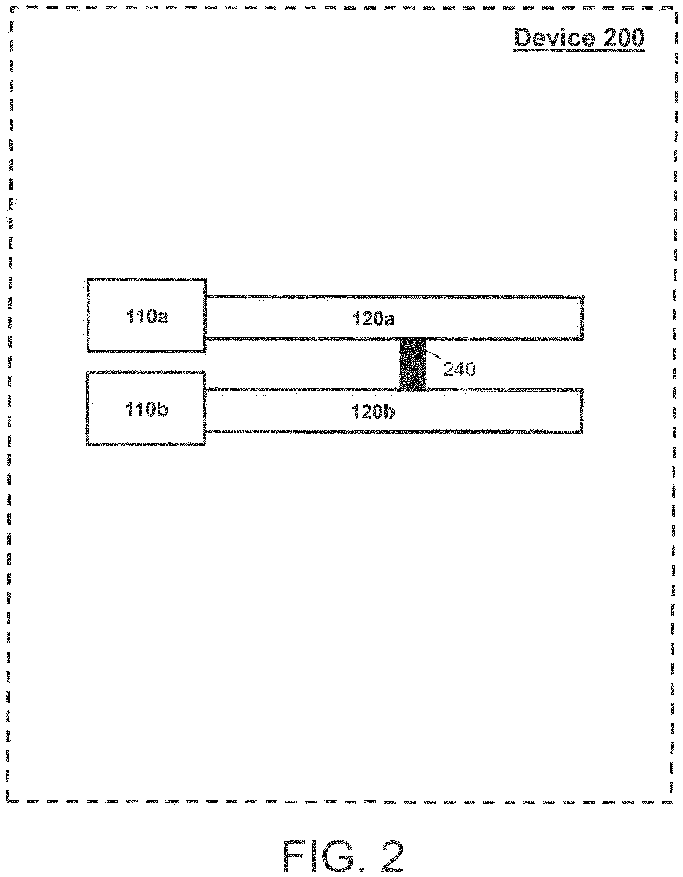

FIG. 2 is another example of a schematic of a device 200 not falling within the scope of claim 1. The device 200, as illustrated includes connectors 110a, 110b, printed wiring boards 120a, 120b, and a combined inter printed wiring board connector 240.

The combined inter printed wiring board connector 240 is a conductive trace that electrically and mechanically connects the printed wiring boards 120a, 120b to enable communication. The combined inter printed wiring board connector 240 can also serve as a rigid stiffener that mechanically supports the alignment of (e.g., stabilizes from movement) the printed wiring boards 120a, 120b in parallel as a single processing device 200. For instance, the combined inter printed wiring board connector 240 secures a strategic positioning, as shown as in FIG. 2, that enables the device 200 to survive a vibration environment of an aircraft.

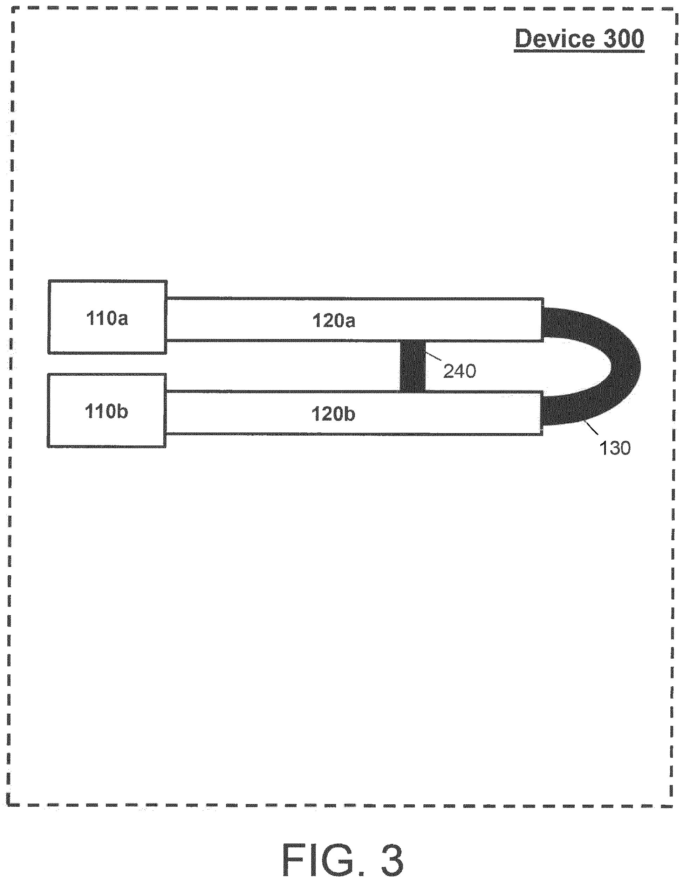

FIG. 3 is another example of a schematic of a device 300 according to one embodiment, where the same reference generally refers to the same components in the embodiments of the present disclosure. The device 300, as illustrated includes connectors 110a, 110b, printed wiring boards 120a, 120b, the flex connector 130, and the combined inter printed wiring board connector 240. In this embodiment, both the flex connector 130 and the combined inter printed wiring board connector 240 are utilized together to provide mechanical and/or electrical support to the device 300. In this way, either or both of the flex connector 130 and the combined inter printed wiring board connector 240 can provide conductive traces between the printed wiring boards 120a, 120b. Further, either or both of the flex connector 130 and the combined inter printed wiring board connector 240 can provide mechanical support between the printed wiring boards 120a, 120b, and thus allowing for the printed wiring boards 120a, 120b to align in parallel as a single processing device 300.

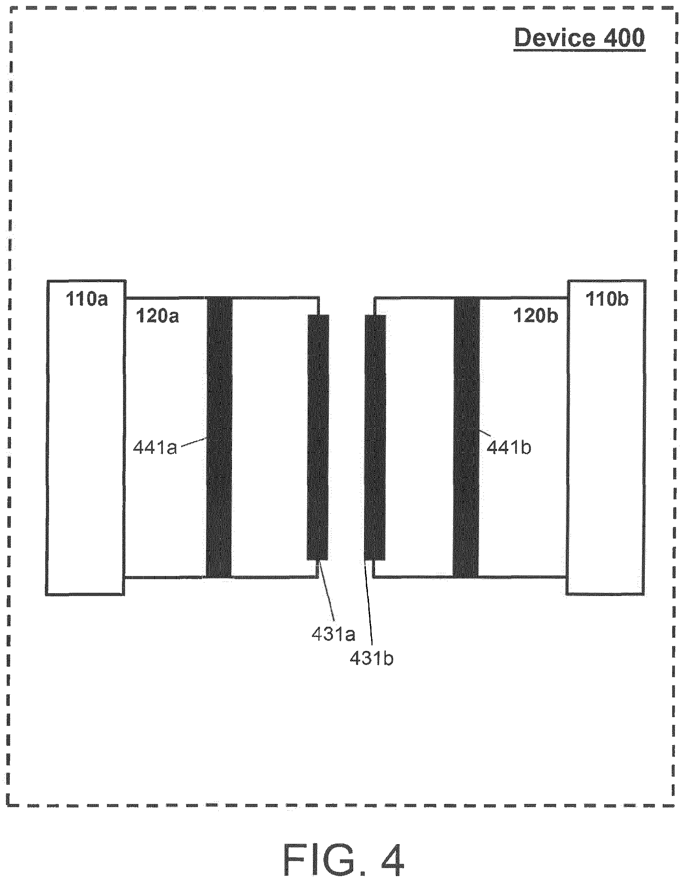

FIG. 4 is another example of a schematic of a device 400 not falling within the scope of claim 1. The device 400, as illustrated includes connectors 110a, 110b, printed wiring boards 120a, 120b, a flex slots 431a, 431b, and connector slots 441a, 441b. The flex slots 431a, 431b enable a mechanical, an electrical, or a mechanical and electrical flex connector 130 to connect the printed wiring boards 120a, 120b. Similarly, the connector slots 441a, 441b enable a mechanical, an electrical, or a mechanical and electrical printed wiring board connector 240 to connect the printed wiring boards 120a, 120b. Thus, any mechanical and electrical combination of the flex connector 130 and the combined inter printed wiring board connector 240 may be assembled in the device 400.

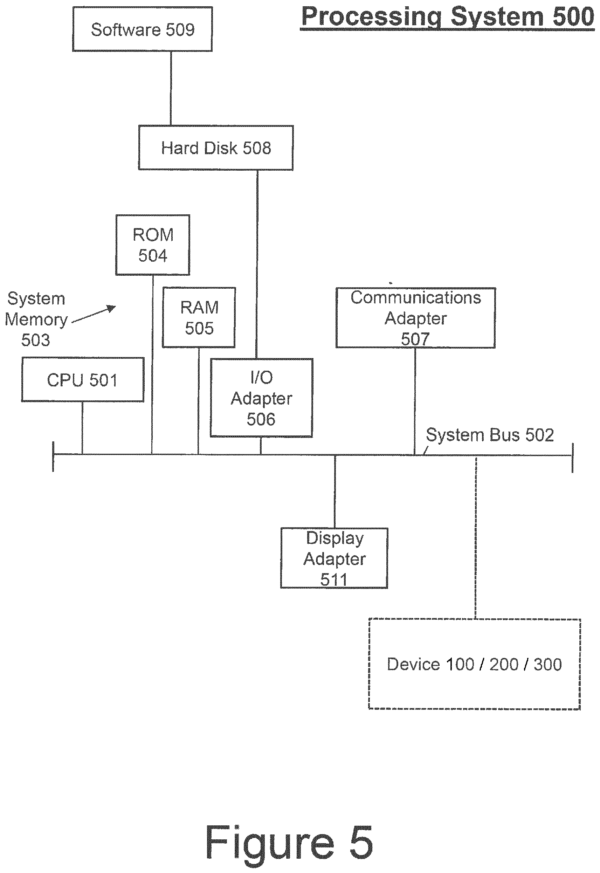

Referring now to FIG. 5, there is shown a processing system 500 for implementing the teachings herein. The processing system 500 has one or more central processing unit (collectively or generically referred to as processor(s) 501). The processors 501, also referred to as processing circuits, are coupled via a system bus 502 to a system memory 503 and various other components. The system bus 502 represents one or more of any of several types of bus structures, including a memory bus or memory controller, a peripheral bus, an accelerated graphics port, and a processor or local bus using any of a variety of bus architectures. By way of example, and not limitation, such architectures include Industry Standard Architecture (ISA) bus, Micro Channel Architecture (MCA) bus, Enhanced ISA (EISA) bus, Video Electronics Standards Association (VESA) local bus, and Peripheral Component Interconnect (PCI) bus.

The processing system 500 typically includes a variety of computer system readable media. Such media may be any available media that is accessible by the processing system 500, and it includes both volatile and non-volatile media, removable and non-removable media. For example, a read only memory (ROM) 504 is coupled to the system bus 503 and may include a basic input/output system (BIOS), which controls certain basic functions of the processing system 500. Further the system memory 503 can include a random access memory (RAM) 505, which is read-write memory coupled to the system bus 302 for use by the processors 501.

Figure 5 further depicts an input/output (I/O) adapter 506 and a communications adapter 507 coupled to the system bus 502. The I/O adapter 506 may be a small computer system interface (SCSI) adapter that communicates with a hard disk 508 and/or tape storage drive or any other similar component. The I/O adapter 506 and the hard disk 508 can be collectively referred to as mass storage. Software 509 for execution on processing system 500 may be stored in mass storage. The mass storage is an example of a tangible storage medium readable by the processors 501, where the software 509 is stored as instructions for execution by the processors 509 to perform operations that improve the performance of the processing system 500.

The communications adapter 507 interconnects the system bus 502 with outside networks enabling the processing system 500 to communicate with other such systems. A screen (e.g., a display monitor) can be connected to the system bus 502 by a display adapter 511, which may include a graphics controller to improve the performance of graphics intensive applications and a video controller. In one embodiment, the adapters 506, 507, and 511 may be connected to one or more I/O buses that are connected to the system bus 511 via an intermediate bus bridge (not shown). Suitable I/O buses for connecting peripheral devices such as hard disk controllers, network adapters, and graphics adapters typically include common protocols, such as the Peripheral Component Interconnect (PCI). Additional input/output devices, such as a keyboard, a mouse, a speaker, etc., can be interconnected to the system bus 502 via user other adapters, which may include, for example, a Super I/O chip integrating multiple device adapters into a single integrated circuit.

Figure 5 further depicts a dashed box representing at least one of the above devices 100, 200, 300 coupled to the system bus 502. The inclusion of the above devices 100, 200, 300 into the processing system 500, in turn, produce the technical effects and benefits of a removal of the printed wiring board backplane and creation of additional space in the processing system 500 for control circuitry, as well as a lighter and smaller processing system 500. An additional technical effect and benefit is that processing the devices 100, 200, 300 as a single unit through the electronics manufacturing process creates cost benefits as compared to manufacturing one printed wiring board backplane and multiple printed wiring board slot cards. In this way, the processing system 500, which may be an electric system controller within an aircraft, will provide fuel efficiency benefits to the aircraft due to the incorporation of at least one of the devices 100, 200, 300, instead of the printed wiring board backplane.

The invention is not to be seen as limited by the foregoing description, but is only limited by the scope of the appended claims.

## Claims

1. A unified manufacturing process for manufacturing an apparatus comprising a first connector (110a), a first printed wiring board (120a), a second connector (110b), and a second printed wiring board (120b), wherein the first connector (110a) communicatively couples the first printed wiring board to a processing system and the second connector (110b) communicatively couples the second printed wiring board to the processing system, the process comprising:
providing a printed wiring board connector (240) configured to be a rigid stiffener and a flex connector (130) configured to electrically connect the first and second printed wiring boards
processing, coating and cleaning the flex connector and the printed wiring boards as a single unit;
folding said single unit on itself to enable a parallel alignment of the first and second printed wiring boards; and
utilizing the printed wiring board connector to mechanically hold the first and second printed wiring boards in the parallel alignment once the apparatus is folded.

## Patentansprüche

1. Einheitliches Herstellungsverfahren für die Herstellung einer Vorrichtung, die einen ersten Steckverbinder (110a), eine erste gedruckte Leiterplatte (120a), einen zweiten Steckverbinder (110b) und eine zweite gedruckte Leiterplatte (120b) umfasst, wobei der erste Steckverbinder (110a) die erste gedruckte Leiterplatte kommunikativ an ein Verarbeitungssystem koppelt und ein zweiter Steckverbinder (110b) die zweite gedruckte Leiterplatte kommunikativ an das Verarbeitungssystem koppelt, das Verfahren umfasst Folgendes:
Bereitstellen eines gedruckten Leiterplattensteckverbinders (240), als ein unbiegsames Versteifungsglied konfiguriert, und eines flexiblen Steckverbinders (130), konfiguriert, um die erste und zweite gedruckte Leiterplatte elektrisch zu verbinden;
Verarbeiten, Beschichten und Säubern des flexiblen Steckverbinders und der gedruckten Leiterplatten als eine einzige Einheit;
Falten der einzigen Einheit auf sich selbst, um eine parallele Ausrichtung der ersten und zweiten gedruckten Leiterplatte zu ermöglichen; und
Verwenden des gedruckten Leiterplattensteckverbinders, um die erste und zweite gedruckte Leiterplatte mechanisch in der parallelen Ausrichtung zu halten, sobald die Vorrichtung gefaltet ist.

## Revendications

1. Procédé de fabrication unifié pour la fabrication d'un appareil comprenant un premier connecteur (110a), une première carte de câblage imprimé (120a), un second connecteur (110b) et une seconde carte de câblage imprimé (120b), dans lequel le premier connecteur (110a) couple en communication la première carte de câblage imprimé à un système de traitement et le second connecteur (110b) couple en communication la seconde carte de câblage imprimé au système de traitement, le procédé comprenant :
la fourniture d'un connecteur de carte de câblage imprimé (240) configuré pour être un raidisseur rigide et d'un connecteur souple (130) configuré pour connecter électriquement les première et seconde cartes de câblage imprimé ;
le traitement, le revêtement et le nettoyage du connecteur souple et des cartes de câblage imprimé comme une unique unité ;
le repliement de ladite unique unité sur elle-même pour permettre un alignement parallèle des première et seconde cartes de câblage imprimé ; et
l'utilisation du connecteur de carte de câblage imprimé pour maintenir mécaniquement les première et seconde cartes de câblage imprimé dans l'alignement parallèle une fois que l'appareil est plié.
